# EUROPEAN PATENT APPLICATION

(11) **EP 1 317 166 A2**
(43) Date of publication of application: **04.06.2003**
(21) Application number: 02425716.4
(22) Date of filing: 22.11.2002
(51) Int. Cl.: H05B 33/04, H01L 51/20, B01D 53/26

(54) **Moisture sorbing device of reduced thickness and process for the manufacture thereof**

(30) Priority: 30.11.2001 IT MI20012524
(71) Applicant: SAES GETTERS S.p.A., 20020 Lainate (Milano) (IT)
(72) Inventor: della Porta, Anna, 20121 Milano MI (IT)
(74) Representative: Adorno, Silvano

(57) **Abstract**

There is disclosed a moisture sorbing device (10,20) having a reduced thickness, which is particularly used in light emitting organic diodes screens.

The device comprises a membrane (11) with a perimetral edge (12) and at least depressions (13,13'). A mono-adhesive sheet (15) or bi-adhesive sheet (21) is fixed to the membrane along the whole perimetral edge, thus defining with the membrane at least two closed spaces at the said depressions formed in the membrane. A moisture sorbing material (19) with a water equilibrium pressure lower than 10⁻² mbar between -15°C and 130°C is positioned in the said closed spaces. A method for manufacturing the moisture sorbing device is also disclosed.

## Description

The present invention relates to a humidity sorbing device of reduced thickness and to a process for the manufacture thereof.

The device of the invention is useful to be used in all applications wherein it is necessary to protect an atmosphere from humidity, but the space available for the humidity sorbing device is reduced. The main expected application is in the screens comprising organic light emitting diodes; in the remaining description it will be referred to the use in these screens, to which however the device of the invention is not limited.

The light emitting organic diodes are being studied in the last years for the manufacture of flat screens, of very low thickness and weight. The main applications expected in the short period are as luminous screens for cellular telephones, for stereo equipments, for car dashboards and the like, but the manufacture of screens of large size and capable of reproducing moving images, to be used for example as computer or television screens, is not excluded.

Organic light emitting diodes are better known in the specialized literature under its acronym OLED, that will be used in the rest of the text. The same term OLED is used to indicate, besides the single diodes constituting punctiform luminous sources, also the screens formed of a plurality of such diodes.

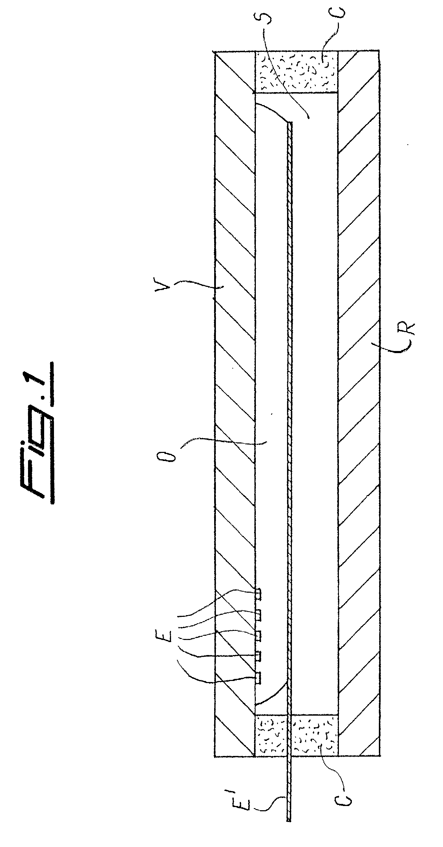

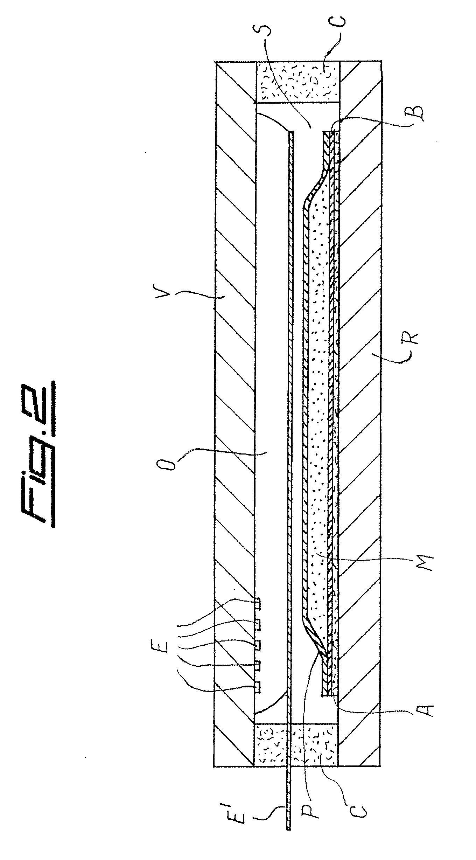

In brief, the structure of an OLED (schematized in the sectional view shown in figure 1) is formed of a first transparent support V, essentially planar and generally made up of glass or of a plastic polymer; a first series of electrodes, E, transparent linear and parallel to each other, deposited on the first support; a double layer, O, of different electro-luminescent organic materials, of which the first is electron conductor and the second is conductor of electronic vacancies, deposited on the first series of electrodes; a second series of electrodes, E', linear and parallel to each other and orthogonally orientated with respect to those of the first series, contacting the upper part of the double layer of organic materials, so that the latter is comprised between the two series of electrodes; and a second support, R, not necessarily transparent, which may be made up of glass, metal or plastic, essentially planar and parallel to the first support. The two supports are fixed to each other along their perimeter, generally through gluing with a glue C, so that the active part of the structure (electrodes, electro-luminescent organic materials) is in a closed space, S. The transparent support, V, is the area in which the image is visualized, while the second support, R, has generally only the function of closing and backing the device, to give enough mechanical resistance to the same.

The material forming the first series of transparent electrodes is commonly ITO, a mixture of tin and indium oxides, however also other mixtures of oxides can be used, generally based on tin or zinc oxide, conductor polymers as polyimides or extremely thin layers (hundreds of Angstrom) of metals having a high electric conductivity, as Al, Cu or Au.

The material of the second series of electrodes may be one of those above listed for the first series or, in the case of non transparent electrodes, may be metal; materials more commonly used are the Al-Li or Al-Mg alloys or composite double layers made up of aluminum on which thin layers of alkaline or alkaline-earth metals or compounds thereof are deposited; examples of these composite double layers are Al-LiF or Al-Li₂O.

Electro-luminescent organic materials can be in the form of discrete molecules or polymeric, but they are, in any case, polyunsaturated; the most commonly used compound is a complex of aluminum with quinoline.

For an exposition of the OLED working principles and for further details about their structure it is to be referred to the literature of the field.

The main problem found with these devices is the rapid loss of their light emitting features due to humidity sorption. The life of these devices is reduced from thousands or tens of thousands of hours in the absence of humidity, as experimentally verified in suitable controlled atmosphere rooms, to a few hours when exposed to atmosphere. Even if the mechanism of the OLED functional degradation have not been yet completely cleared, it is probable that the phenomenon is ascribable to addition reactions of the water molecule with the unsatured bonds of the organic component on one hand, and, on the other hand, to the reaction of the water with electrodes, particularly metallic cathodes. The main inlet channel of the water into the OLEDs is the perimetrical soldering of the two supports, usually made by gluing through water permeable epoxidic resins, used by nearly all the constructors. Humidity can also be released by the same OLED internal components.

Patents USA 5,804,917 and USA 5,882,761 and the publications of international application WO 98/59356 and WO 99/35681 disclose the use of humidity sorbing materials inside the devices. However, all these documents indicate generically the use of sorbing material, and do not explain how it is possible to integrate the step of introducing the sorbing material inside the OLED in the manufacturing process of the device.

The research publication RD 430061 offers, compared to the above mentioned documents, a detailed description of the structure of a possible humidity sorbing device for OLEDs. This device is generically formed of a rectangular sheet of aluminum-polyethylene double layer with a central recess wherein a powder humidity sorbing material (for example, CaO) is located; along the edges of the aluminum sheet is thermosealed a sheet of a polymeric material that is water permeable, but able to retain the powder particles of the sorber, for example a polyethylene nonwoven fabric. The assembly is a discrete object which can be placed in the OLED internal space (S), generally in contact with the second support (R) in such a way that the water permeable sheet faces the active structure, formed of the electrodes (E, E') and of the organic double layer (O).

However, also the system disclosed in RD 430061 presents some drawbacks relating to its use. In fact, it is necessary that the sorbing device does not come in contact with the electrodes or with the layers of organic materials in order to prevent them from being damaged by compression or rubbing, and thus the sorbing device must be arrangeable in the space S of the OLED in such a way to occupy only the lower part thereof: at present, the demand of the OLED manufacturers is directed to sorbing devices of such a thickness that the maximum height in every single part thereof is about 0.4 mm with respect to the second support R. In RD 430061 system, the aluminum-polyethylene double layer, which has to give mechanical consistency to the whole, cannot be less thick than about 0.065 mm, while the nonwoven fabric is generally at least 0.1 mm thick; furthermore this device has to be fixed to the second support R, commonly through glues or biadhesive tape, having a thickness of about 0.01-0.03 mm. Finally, the overall sorbing device may be deformed with respect to the ideal planar shape, both just after the manufacture and following to the step of introduction into the OLED, thus occupying a higher thickness than the theoretic one, with the above mentioned risks of damaging the electrodes or the organic layers: it obliges to further reduce the "theoretic" thickness to grant a margin of safety which considers these possible dishomogeneities. It follows that the thickness available for the sorbing material is, at best, of 0.2 mm, while it would be preferable to be able to increase the amount of material loaded in the device to assure a better sorbing capability.

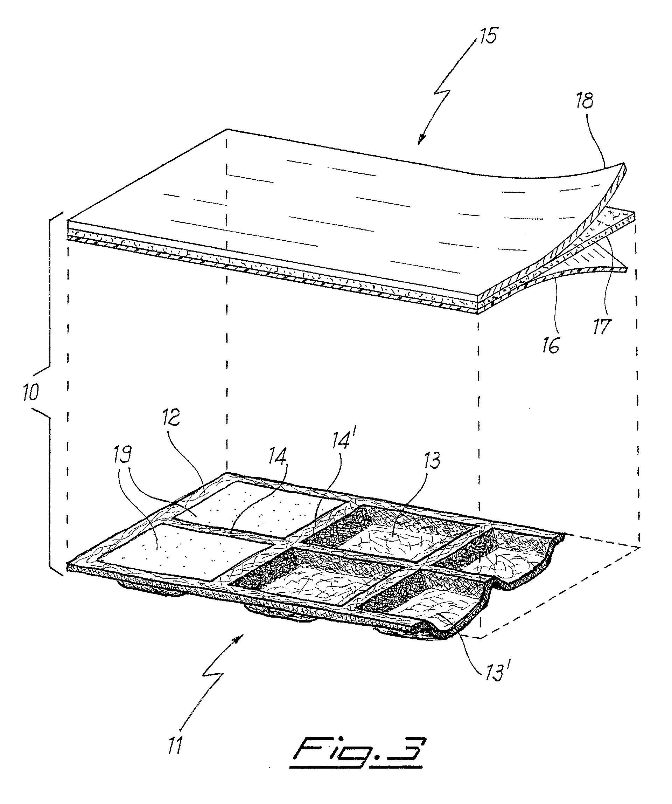

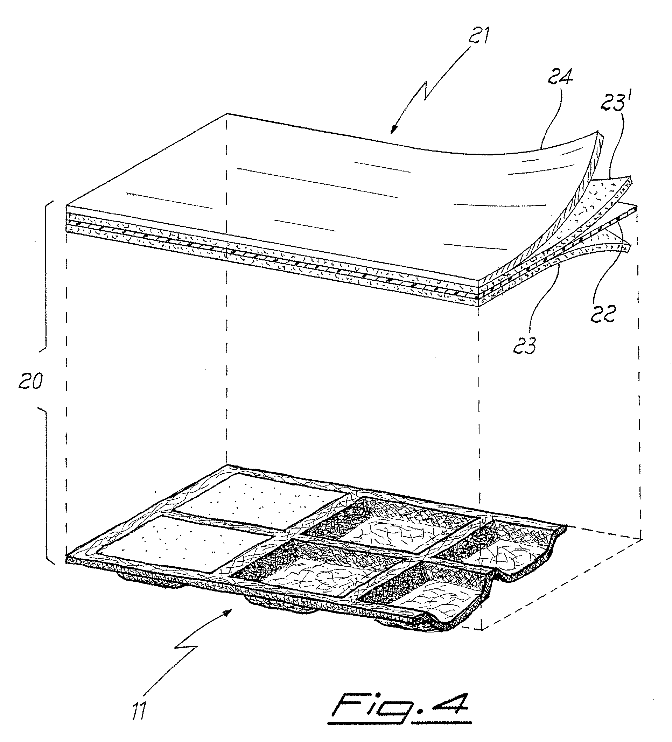

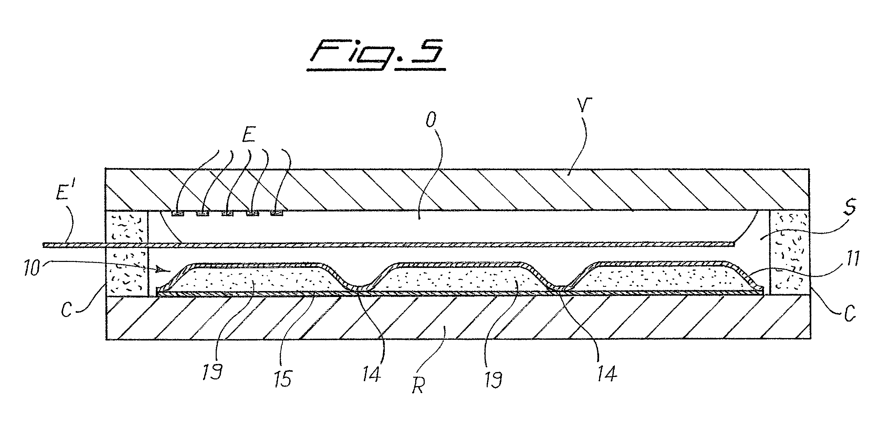

Italian patent application MI2000A002098 in the name of the Applicant represents an improvement in comparison with the devices of the prior art. This application describes a humidity sorbing system wherein the component parts are present in "overturned" structure with respect to what is known, wherein the recess intended to contain the sorbing material is obtained through pressing in the water permeable membrane, and the device is then completed by a sheet of a material impermeable to the fluids. An OLED containing a similar sorbing device is schematically represented in sectional view in figure 2 (wherein symbols equal to those of figure 1 have the same meaning): into space S is inserted the device formed of permeable membrane P and impermeable sheet B, between which the sorbing material M is contained; the device is in contact with the second support R through sheet B. This configuration is such that also the sealing edge between membrane P and sheet B is in contact with support R, thus avoiding the risk that deformations thereof may bring it into contact with the OLED active structure; furthermore, since in this case the part which gives mechanical resistance to the device is the membrane P, it is possible to reduce the thickness of the sheet B to values lower than about 0.065 mm required in the previous configuration, thus increasing the space available for the material M. Anyway also this system requires, to be fixed to support R, the use of a layer of glue or of a biadhesive tape (generically indicated in figure as element A), which contribute to the total thickness of the device to the detriment of the space available for the material M.

The object of the present invention is to provide a humidity sorbing device of reduced thickness, as well as to provide a process for the manufacture of this device.

These objects are achieved according to the present invention which in a first aspect relates to a device made up of:
- a membrane permeable to water but able to retain solid particles, formed in such a way to present a continuous external edge and at least two depressions with respect to the level of said edge separated one from the other by at least one area at the same level of the edge;
- a monoadhesive or biadhesive sheet able to retain solid particles and fixed to the membrane along the whole perimetrical edge and said area at the same level of the edge, defining together with the membrane at least two closed spaces at said depressions of the membrane itself;
- a humidity sorbing material with a water equilibrium pressure lower than 10⁻² mbar between -15°C and 130°C in said closed spaces.

The inventors have found that the glues used in the manufacture of sheets or mono- or biadhesive tapes have a good rate of water permeation, in such a way that even if the glue comes in contact with the humidity sorbing material, the rate of water sorption thereof remains sufficiently high; consequently it is possible to completely eliminate the impermeable sheet (for example made of metal, plastic or plastic-metal bilaminated) which was one of the elements constituting the sorbing devices of the prior art, by substituting it with a mono- or biadhesive sheet and thus increasing the thickness available for the humidity sorbing material.

Further advantages and features of the invention will be evident to those skilled in the art from the following detailed description with reference to the drawings wherein:
- Fig. 1 shows schematically the cross-section of an OLED screen;
- Fig. 2 shows in cross-section and schematically an OLED screen comprising a humidity sorbing device according to the prior art;
- Fig. 3 shows an exploded view of a humidity sorbing device according to a first embodiment of the invention;
- Fig. 4 shows an exploded view of a humidity sorbing device according to an alternative embodiment of the invention;
- Fig. 5 shows schematically and in cross-section an OLED screen containing a humidity sorbing device of the invention;
- Fig. 6 represents the main steps of the manufacture process of a single device of the invention; and
- Fig. 7 represents the main steps of a continuous process for manufacturing the device of the invention;
- Fig. 8 represents the result of a batch production process of the device of the invention.

For the sake of description clarity, the elements shown in the figures are not in scale, and in particular the thickness values are very enlarged with respect to lateral dimensions. Furthermore, the application examples refer to the use in OLEDs but, as already said, the device of the invention can find applications also in other systems when the available thickness is small.

Figures 1 and 2 have already been described during the discussion of the prior art.

The device of the invention is formed of a membrane (11) and a mono- (15) or biadhesive (21) sheet fixed to each other along their perimeter (12) and along the areas (14, 14') dividing the depressions (13, 13') obtained in the membrane and wherein the humidity sorbing material (19) is located.

The membrane has the function of confining the sorbing material in a defined portion of the space S of an OLED screen, allowing in the meantime the humidity present in said space to get in contact with the sorbing material easily and rapidly. For the purpose, the membrane shall have preferably a conductivity for water higher than 0.1 mg/(hour x cm²). The membrane must further have a sufficient mechanical consistency, so as to be shapeable through pressing. Said membrane can be of the type with homogeneous dimensions and distributions of the holes; a similar membrane can be formed of a metallic net, a polymeric fabric or of a metallic or micropierced polymeric sheet. Among these, for economic and lightness reasons, it is preferable the use of polymeric material membranes. These membranes must have holes not bigger than 20 µm, so as to be able to retain the powders of the sorbing material. Alternately, it is possible to use membranes with not uniform distribution and dimensions of pores, as for example the aluminum sheets of thickness of 4 or 5 µm, produced by the Japanese company Toyo, which have random distribution microholes or, preferably, nowoven fabric membranes. Typical nowoven fabric membranes are those made of polyethylene, for example at high density (known in the sector as HDPE); membrane of this type are commercially available with the definition Tyvek® (registered trade-mark by the company du Pont de Nemours). It has been empirically determined that a HPDE nowoven fabric having a thickness of at least 0.12 mm has all the features required for the invention, that is it is rigid enough to be shapeable through pressing, has the required values of rate of water permeation and a device of the invention realized with this membrane does not leak particles of the solid material. The thickness of a nowoven tissue membrane suitable for the objects of the invention is preferably not bigger than 0.15 mm: membranes of bigger thickness would obviously satisfy the requirement of mechanical resistance, but they would reduce uselessly the available thickness for the humidity sorbing material.

The humidity sorbing material can be any material having a water equilibrium pressure lower than 10⁻² mbar in the whole field of temperatures of expected use of the OLED screens, about between -15°C and 130°C. Among these materials, preferred are the oxides of alkaline-earth metals, as CaO, SrO and BaO; particularly preferred is CaO because it implies no safety or environmental problems during the manufacturing steps or in the OLED digestion, and because its low cost. The sorbing material is preferably in the form of a powder, with particle size generally lower than 300 µm, and preferably included between 10 and 100 µm. It is possible to add powder of other materials to the humidity sorbing material, for example small amounts of inert materials such as alumina, with the function of preventing the material from an excessive packing following to water sorption, or the materials which sorb other gases, as for example oxygen, hydrogen or carbon oxides.

Mono- or biadhesive sheets (or tapes) are well known and widely used in numerous technological applications. These sheets or tapes are generally formed of a support (a thin sheet of plastic material) on one or both surfaces of which there is a layer of adhesive material. For example, the support can be made up of polyethylene terephthalate (PET), with thickness included between 4-5 and 10-20 µm, while the adhesive layers are made up of acrylic materials with thickness values of the order of a few tens of microns. Sheets or adhesive tapes of this type are commercially available for example from the Japanese company Nitto-Denko, with number of catalogue HJ-3160W, or from the Japanese company Teraoka with number of catalogue 707: this last sheet has a total thickness of about 30 µm, and is therefore particularly suitable at purposes of thickness reduction of the device of the invention.

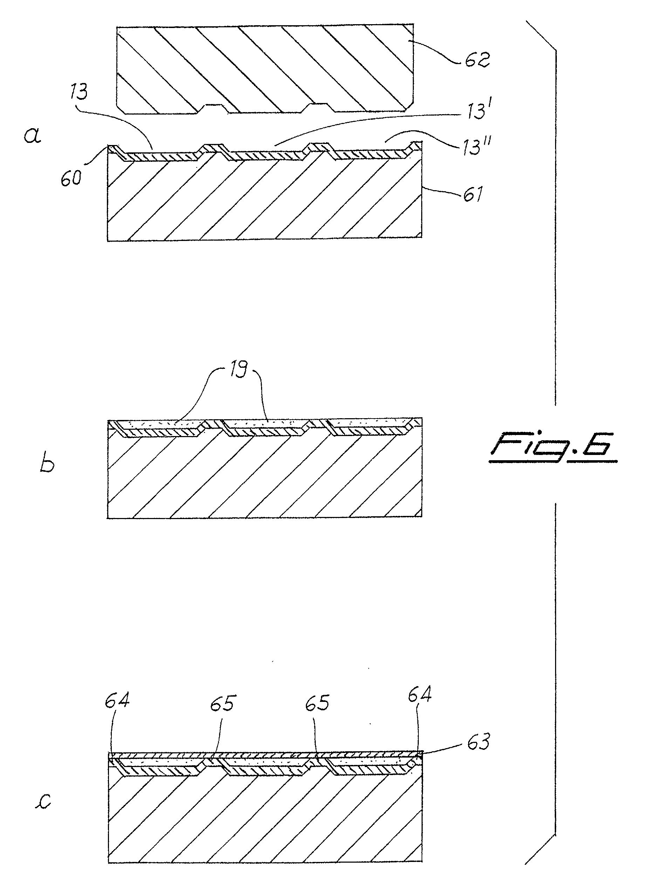

Figure 3 shows in an exploded and partially cut-out view, a first possible humidity sorbing device of the invention. Device 10 is formed of a membrane 11 formed, generally through pressing, in such a way to have an external edge, 12, and depressions, 13, 13', divided one from the other by areas, 14, 14', at the same level of the edge; the dotted lines at the right side of the membrane represent the effective sizes thereof. The membrane is exemplified as made up with a fiber-based material, as in the case of Tyvek®. To membrane 11, along the whole edge and the areas 14, 14', is fixed a monoadhesive sheet, 15, formed of a polymeric sheet 16 supporting a layer of adhesive material 17, temporarily protected from non-adhesive tape 18. Sheet 15 is fixed to membrane 11 along the whole external area 12 and the areas 14, 14', with the polymeric sheet 16 in contact with membrane 11. The fixing can be carried out through gluing or thermosoldering depending on the type of membrane used; particularly it is always possible to fix through glues, while, if the membrane is made with polymeric materials, the fixing can be carried out by thermosoldering, generally by using compressing bars heated at temperatures of about 100°C as known in the art. Depressions 13, 13' together with sheet 15, define spaces filled with the humidity sorbing material 19; in the figure, in order to accentuate all the elements constituting the device of the invention, only two of these spaces are illustrated filled with material 19, but in the real devices the latter obviously fills completely said spaces. Non-adhesive film 18, is removed just before the placement of device 10 into its final housing, thus exposing the adhesive material 17 through which the device 10 is fixed to a wall of the room to be kept without humidity; in the case of an OLED screen, this is the second support R.

Figure 4 shows a possible alternative embodiment of the device of the invention. Device, 20, is analogous to that of figure 3 (analogous elements in the two figures are indicated by the same numbers), but in this case instead of the monoadhesive sheet 15 is used a biadhesive one 21, formed of a polymeric sheet 22 which supports on both faces layers of adhesive material 23, 23'; layer 23' is protected, before introducing device 20 in the OLED, by the non-adhesive film 24. The fixing between membrane 11 and sheet 21 can still occur through thermosoldering, but gluing can be preferable in this case, exploiting the layer of adhesive material 23.

Figure 5 schematically shows a section of an OLED containing a humidity sorbing device of the invention (the case of device 10 is exemplified): the device 10 has membrane 11 directed towards space S and the layer of adhesive material 17 (not shown in the figure) of sheet 15 in contact with the second support of the OLED, R. From the comparison with figure 2, it is noticeable how in this case the sheet 15 integrates the functions of sealing device 10 and of adhering to support R, making the sheet B superfluous and increasing consequently the space available for the sorbing material 19.

In a second aspect thereof, the invention relates to a process for the manufacture of a humidity sorbing system, generally comprising the steps of:
- preparing a sheet of a membrane permeable to water but able to retain solid particles and of sufficient mechanical consistency to be shapeable by pressing;
- shaping through pressing said membrane sheet in such a way that it has a continuous external edge and at least two depressions with respect to the level of said edge, divided from each other by at least an area at the same level of the edge;
- filling said depressions with powder of a humidity sorbing material with a water equilibrium pressure lower than 10⁻² mbar between -15°C and 130°C;
- fixing a mono- or biadhesive sheet to the membrane sheet along the whole said external edge and along said area at the same level of the edge.

The process is schematically shown in figure 6; the case wherein the device comprises three depressions is exemplified. During the first step, a, the membrane sheet is placed between a mould 61 and a plunger 62 opportunely shaped, forming three depressions 13, 13', 13" in the sheet. In the following step, b, the depressions 13, 13', 13" are filled to the brim with the powder 19 of the humidity sorbing material (or with a possible mixture thereof with other materials, as described before). The filling to the brim consists in introducing an appropriate quantity of powder material in the depressions, and in removing a possible excess part by "scraping" the sheet 60 surface with a proper blade (not shown). In the step c, upon sheet 60 is placed the mono- or biadhesive sheet 63 and the two sheets are fixed to each other by gluing or thermosoldering along a continuous area 64 around the depressions 13, 13', 13" and along the areas between the depressions, 65, which is at the same level of the area 64. When a biadhesive sheet (device of type 20) is used, the fixing can be made by simply using the adhering properties of layer 23. The protection film 19 or 24 remains in the final device, and will be removed just before the positioning of the device of the invention in an OLED.

The process described up to this point is related to the production of a single sorbing device at a time, but obviously, for manufacturing and economic reasons, the process is preferably carried out in continuous, using both the sheet constituting the membrane and the mono- or biadhesive sheet in the form of tapes continuously fed to the stations of forming the depressions, filling with sorbing material and closing with adhesive sheet; alternatively, the devices of the invention can be produced in batch, using sheets of large sizes and carrying out the above mentioned steps simultaneously on many device.

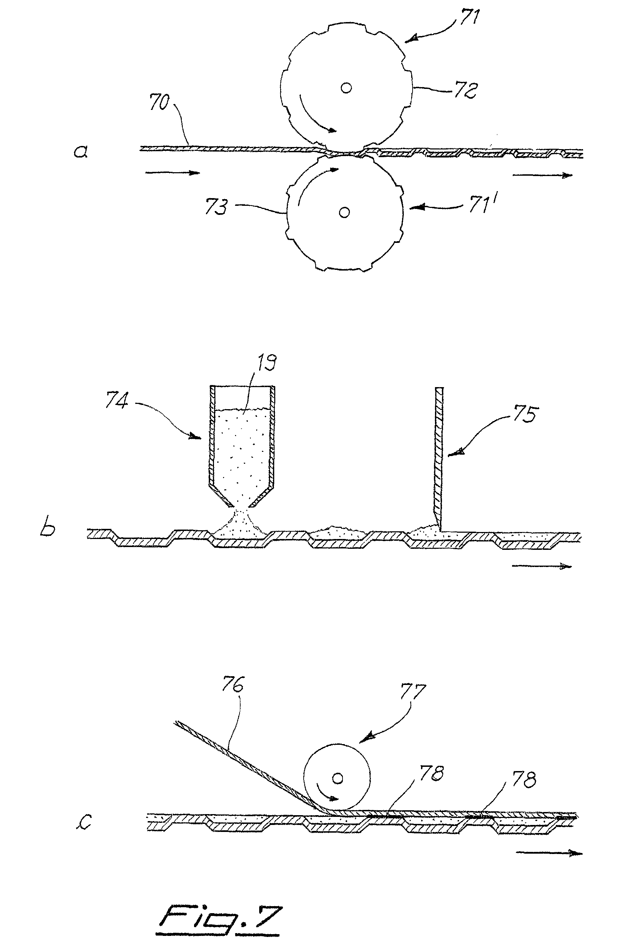

The first possibility (continuous production) is schematically represented in figure 7; the arrows indicate the direction of motion of the belt. In this case the step a is carried out by unrolling a tape 70, made with the material of the membrane 11, from a spool (not shown), and by making said tape flow between two rollers opportunely shaped, 71, 71', one of which has relieves 72 on its surface and the second corresponding depressions 73. The step **b** is carried out by passing tape 70 first under a station 74 of supply of the powder of humidity sorbing material 19 (or mixture containing this material); station 74 can be for example a hopper. Then the tape is driven under element 75, which removes the excess of material 19 from the surface of tape 70; this last step can be favoured for example by tape vibration. Finally, step c is carried out by passing tape 70 with the depressions thereof filled up with material 19, together with a mono- or biadhesive tape 76 (respectively corresponding at sheets 15 or 21), under a compressing and/or heating roll 77 which realizes the fixing of sheets 70 and 76 in areas 78 (at areas 14, 14', ... of figure 3) and along the whole perimeter of the two tapes; also tape 76 is appropriately unrolled from a spool, not shown in figure. From the so obtained continuous coupled tape, devices of type 10 or 20 are obtained by proper cuts made along areas 78 (step not shown).

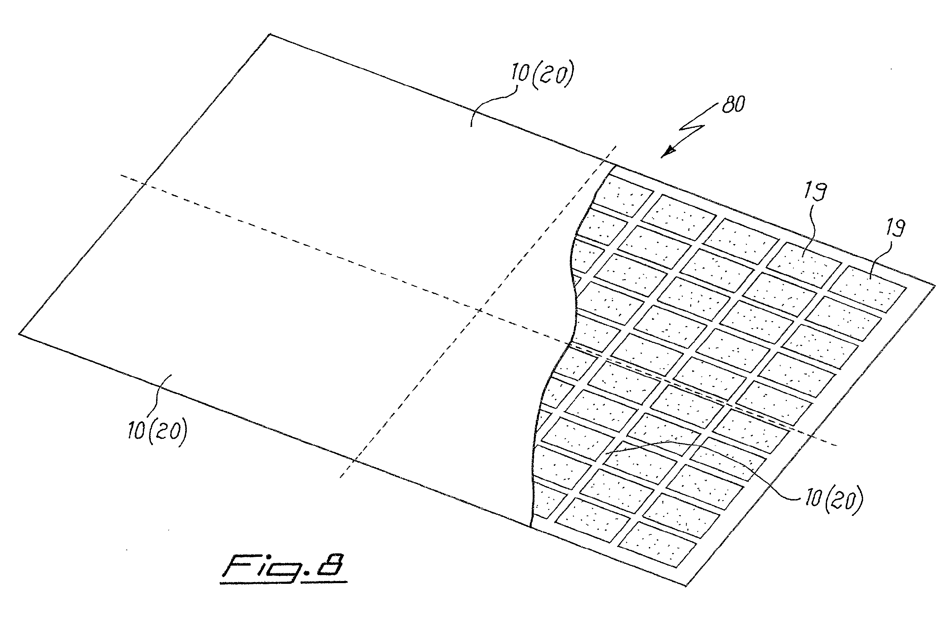

Figure 8 represent a partial cut-out view of a possible result of the batch production process. In this case is obtained a manufactured article, 80, comprising a plurality of depressions filled up with the material (or mixture) 19; from this, by cutting along the dotted lines at the areas of type 14, 14', many devices of the invention, 10 (or 20) are obtained; there is exemplified the case wherein four devices are obtained from manufactured article 80 , each of which comprises a 5 x 5 matrix of depressions filled up with material 19.

It is also possible an intermediate process between the continuous and the batch one (case not shown in the figures). In this case, use is made of a multiple mould and plunger of type 61 and 62 respectively, and a continuous sheet of type 70 is advanced between them; the advancing occurs by "steps" of length equivalent to that of the mould measure in the direction of the advancing of the sheet. The pressing of the membrane, the filling thereof with the powder 19 and the fixing of the mono- or biadhesive sheet are carried out through discrete phases as in the process exemplified with reference to figure 6.

In every process in which many systems (continuous, batch or mixed) per time are produced, if the lateral sizes of devices 10 or 20 are known beforehand, it is also possible to design the areas 14, 14', along which the cuttings to divide the different device will be made (and which will be the edge 12 therein), to have larger width than the areas 14, 14' included in the single devices.

Instead of cutting it is possible to dink the tape, by cutting all the layers but the non-adhesive film (18 or 24) so that this constitutes a support from which the single sorbing systems are taken just before the use, as known in the sector of autoadhesive labels.

The devices of the invention have been represented in the figures as having square or rectangular depressions, preferable shapes because of the greater easiness of the realization especially in the case of the continuous production; however, the depressions can have obviously also different shapes, for example triangular, rhomboidal or hexagonal.

In addition to the above described advantage of increasing the thickness available for material 19, the shape of the device of the invention with many connecting areas between the membrane and the mono- or biadhesive sheet, it increases its mechanical rigidity and makes its manufacturing and storing steps easier. Particularly, by parceling the distribution of the sorbing material in many areas divided one from the other, it is avoided the problem of moving the most of the powder in only one part of the device when it is not kept in horizontal position (this can easily occur during the transportation), which causes thickness dishomogeneities among its different parts with loss of control over the maximum thickness allowed; it is easier during the manufacturing process to fill with a constant thickness of sorbing material a plurality of relatively small depressions than a single depression which occupies the whole surface of the device (except the edge); finally, sheets or rolls including many devices of the invention can be easily folded or rolled, resulting advantageous for the stocking and the transportation.

## Claims

1. Humidity sorbing device of reduced thickness (10; 20) formed of:
- a membrane (11) permeable to water but able to retain solid particles, formed in such a way to have a continuous external edge (12) and at least two depressions (13, 13') with respect to the level of said edge divided from each other by at least one area (14, 14') at the same level of the edge;
- a monoadhesive (15) or biadhesive (21) sheet able to retain solid particles and fixed to membrane along the whole said external edge and said area at the same level of the edge, defining together with the membrane at least two closed spaces at said depressions of the same membrane;
- a humidity sorbing material (19) with a water equilibrium system lower than 10⁻² mbar between -15°C and 130°C in said closed spaces.

2. Device according to claim 1 wherein said membrane has conductivity for water higher than 0.1 mg/ (hour x cm²).

3. Device according to claim 2 wherein said membrane has openings of sizes not larger than 20 µm.

4. Device according to claim 2 wherein said membrane is formed of a metallic screen, a polymeric fabric or a micropierced metallic or polymeric sheet.

5. Device according to claim 4 wherein said membrane is formed of an aluminum sheet of thickness not higher than 5 µm.

6. Device according to claim 2 wherein said membrane is formed of a nonwoven fabric.

7. Device according to claim 6 wherein said nonwoven fabric is made up of high density polyethylene.

8. Device according to claim 7 wherein said membrane has a thickness higher than 0.12 mm.

9. Device according to claim 8 wherein said membrane has a thickness lower than 0.15 mm.

10. Device according to claim 1 wherein the humidity sorbing material is selected among the oxides of alkaline-earth metals.

11. Device according to claim 10 wherein the humidity sorbing material is in the form of powder of particle size lower than 300 µm.

12. Device according to claim 11 wherein said particle size is included between 10 and 100 µm.

13. Device according to claim 10 wherein the humidity sorbing material is CaO.

14. Device according to claim 10 wherein to the humidity sorbing material is added a power of another material selected between alumina and a material able to sorb oxygen, hydrogen or carbon oxides.

15. Process for manufacturing a humidity sorbing system of claim 1 comprising the steps of:
- preparing a sheet (60) of a membrane permeable to water but able to retain solid particles and of sufficient mechanical consistency to be shapeable by pressing;
- forming by pressing said membrane sheet in such a way that it has a continuous external edge (12) and at least two depressions (13, 13') with respect to the level of said edge divided from each other by at least one area (14) at the same level of the edge;
- filling said depressions with powder of a humidity sorbing material (19) with a water equilibrium pressure lower than 10⁻² mbar between -15°C and 130°C;
- fixing a mono- or biadhesive sheet (64) to the membrane sheet along said whole external edge and along said area at the same level of the edge.

16. Process according to claim 15 wherein the formation of said depressions is obtained through pressing by interposing said sheet (60) between a mould (61) and a plunger (62).

17. Process according to claim 15 wherein the step of filling said depressions is carried out through the brimming technique.

18. Process according to claim 15 wherein a biadhesive sheet is used and in said step of fixing the membrane sheet to the biadhesive sheet the properties of adhesion of adhesive layer (23) of the biadhesive sheet are used.

19. Process according to claim 15 to produce in continuous humidity sorbing devices comprising the steps of:
- passing a tape (70) made up of material of said membrane (11) between two shaped rollers (71, 71'), one of which has relieves (72) on its surface and the second corresponding depressions (73), so as to form depressions (13, 13') on upper surface of the tape;
- passing the tape shaped in the previous step first under a station (74) which supplies powder of humidity sorbing material (19) into said depressions, and consequently under an element (75), which removes the excess of humidity sorbing material from surface of said tape;
- passing the tape (70) with said depressions filled up with humidity sorbing material, together with a mono- or biadhesive tape (76), under a compressing and/or heating roll (77) which realizes the fixing of said tape of membrane material and said mono- or biadhesive tape along the whole perimeter of said tapes and in areas 78 included between said depressions.

20. Process according to claim 19 further comprising the step of dividing at least two humidity sorbing devices (10; 20) through cuts along at least one of said areas between the depressions of the tape obtained by the coupling of membrane tape and mono- or biadhesive tape.

21. Process according to claim 19 further comprising the step of dinking the tape obtained by coupling of membrane tape and mono- or biadhesive tape, cutting along at least one of said areas between the depressions all the layers constituting said tapes except the non-adhesive film (18; 24).

22. Process according to claim 15 to batch produce humidity sorbing material comprising the steps of:
- preparing a sheet of membrane (11) material having at least one lateral dimension at least double than the one of the device (10; 20) to be manufactured;
- forming in said sheet a number of depressions multiple of the number of depressions of the device to be manufactured;
- filling the depressions formed in the previous step with a humidity sorbing material or a mixture of powders comprising a humidity sorbing material;
- forming a manufactured article (80) by fixing on the sheet of membrane material having at least one lateral dimension at least double than the one of the device to be manufactured a mono- or biadhesive sheet of the same dimensions.

23. Process according to claim 22 further comprising the step of dividing at least two humidity sorbing devices (10; 20) through cuttings along at least one of said areas between the depressions of said manufactured article.

24. Process according to claim 22 further comprising the step of dinking said manufactured article, by cutting along at least one of said areas between the depressions all the layers constituting the manufactured article except the non-adhesive film (18; 24).
